# EUROPEAN PATENT APPLICATION

(11) **EP 2 763 514 A1**
(43) Date of publication of application: **06.08.2014**
(21) Application number: 14166887.1
(22) Date of filing: 24.12.2010
(51) Int. Cl.: H05K 1/11, H01L 23/12, H05K 3/40

(54) **Interposer substrate and method of manufacturing the same**

(30) Priority: 25.12.2009 JP 2009294989
(62) Divisional of application: 10839574.0
(71) Applicant: Fujikura Ltd., Tokyo 135-8512 (JP)
(72) Inventor: Yamamoto, Satoshi, Chiba, 285-8550 (JP); Suzuki, Takanao, Chiba, 285-8550 (JP); Matsuyama, Masami, Chiba, 285-8550 (JP)
(74) Representative: Cabinet Plasseraud

(57) **Abstract**

A method of manufacturing an interposer substrate that is provided with a planar substrate, and with a through hole interconnection that is formed by filling a through hole that connects together a first main surface and a second main surface of the substrate with a conductor. The through hole has a first aperture portion in the first main surface, and has a second aperture portion in the second main surface. The through hole is formed by irradiating the area of the substrate with laser light, so that when the through hole is viewed in a vertical cross-sectional view of the substrate, the through hole has a trapezoidal shape. The side faces of the trapezoid are not parallel to each other and are both inclined towards the same side.

## Description

### TECHNICAL FIELD

The present invention relates to an interposer substrate having through-hole interconnections that penetrates the interior of a substrate, and to a method of manufacturing this interposer substrate.

### BACKGROUND ART

Conventionally, one method that is used to electrically connect together devices that are individually mounted on a first main surface (i.e., one main surface) and on a second main surface (i.e., an other main surface) of a substrate is a method in which through-hole interconnections that penetrates the interior of the substrate is provided.

As an example of an interposer substrate, Patent document 1 describes an interposer substrate that is provided with through-hole interconnections that is formed by filling through holes which have portions which extend in a different direction from the thickness direction of the substrate with a conductor.

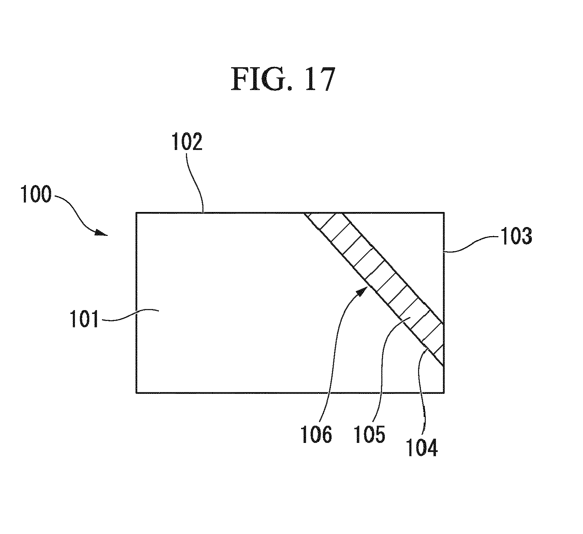

An example of this is shown in FIG. 17.

An interposer substrate 100 is provided with a substrate 101 that is formed from silica glass or the like, and with through-hole interconnections 106 that is formed by filling a through hole 104 which is formed such that it connects together a first main surface 102 and a side surface 103 of the substrate 101 with a conductor 105 such as copper (Cu), tungsten (W), or gold-tin (Au-Sn) or the like.

Conventionally, in order to form this type of through-hole interconnections 106 inside the substrate 101, a method is used in which, firstly, the through hole 104 that extends diagonally through the inside of the substrate 101 is formed.

Next, the interior of the through hole 104 is filled with the conductor 105 by means of a plating method, a sputtering method, a molten metal suction method, a CVD method, or a supercritical fluid deposition method or the like.

Among these methods, using a plating method to fill the through hole with the conductor is most common due to its compatibility with semiconductor processing and the like.

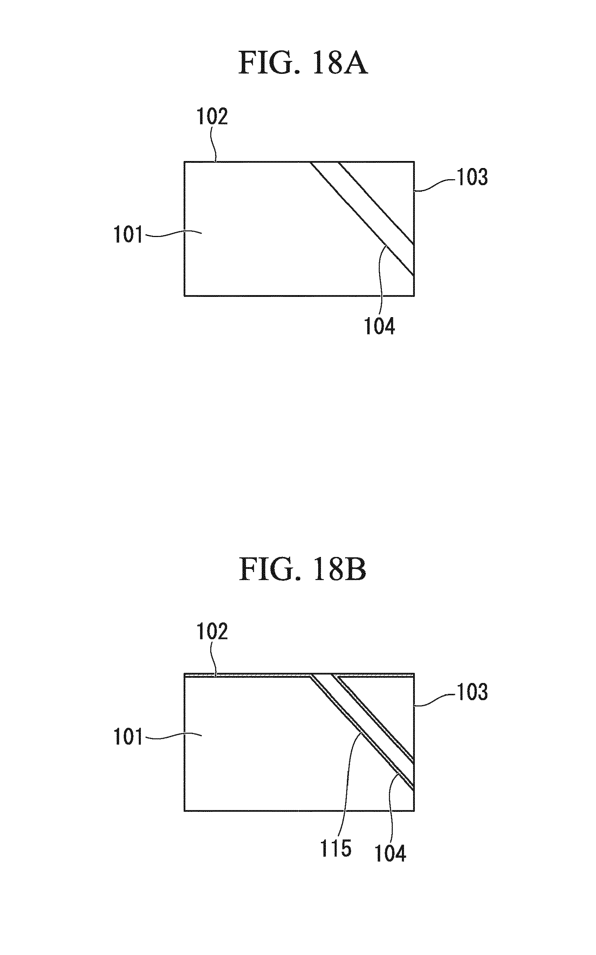

As an example, a conventional method of manufacturing the interposer substrate 100 by means of electroplating is shown in FIGS. 18A through 18D.

Firstly, the through hole 104 that extends in a diagonal direction relative to the first main surface 102 of the substrate 101 is formed in the interior of the substrate 101 (FIG. 18A).

Next, a seed layer 115 for the electroplating is formed on an internal wall surface of the through hole 104 and on the first main surface 102 (FIG. 18B).

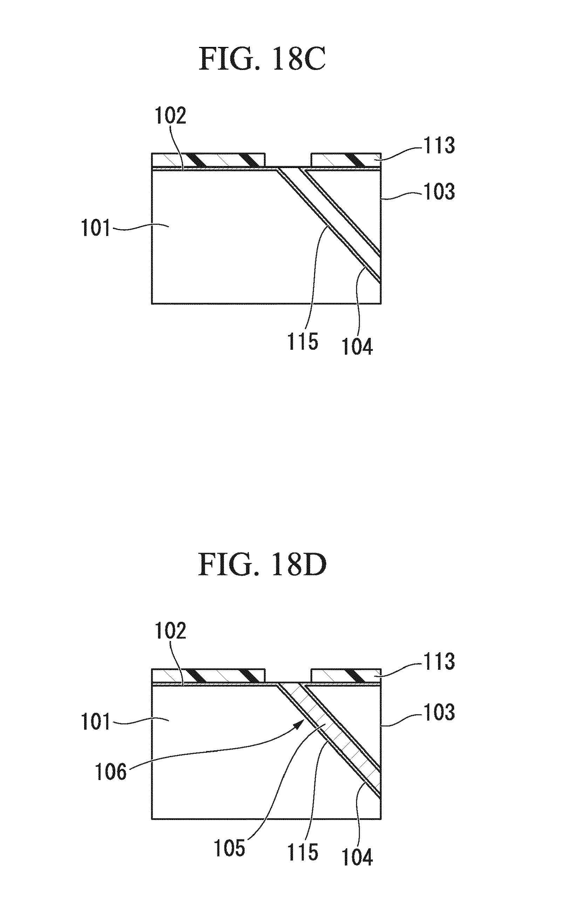

Next, a suitable pattern is created on the seed layer 115 on the first main surface 102 using resist 113 (FIG. 18C).

Thereafter, in order for the interior of the through hole 104 to be filled with the conductor 105 by means of electroplating, the substrate 101 is immersed in a plating solution, and an appropriate current is then supplied between the seed layer 115 and an anode electrode (not shown) that is separately provided in the plating solution.

As a result, the conductor 105 is precipitated in the through hole 104 so as to form the through-hole interconnections 106 (FIG. 18D).

Thereafter, the seed layer 115 and the resist 113 on the first main surface 102 are removed by means of an appropriate method so that the interposer substrate 100 is obtained (FIG. 17).

In FIG. 17, the seed layer 115 is not shown.

The above is a description of a procedure for filling the interior of a through hole with a conductor using an electroplating method, however, it is also possible to fill the interior of a through hole with a conductor using an electroless plating method.

### PRIOR ART DOCUMENTS

### PATENT DOCUMENTS

[Patent document 1] Japanese Unexamined Patent Application Publication No. 2006-303360

### DISCLOSURE OF THE INVENTION

### PROBLEMS TO BE SOLVED BY INVENTION

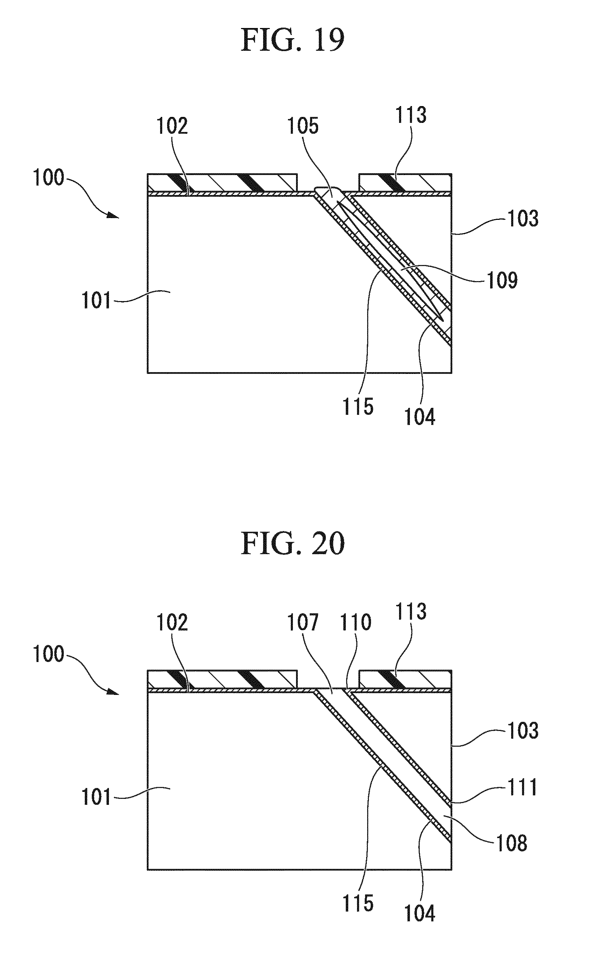

However, in the above-described conventional manufacturing method, during the plating, the problems of a void (i.e., an empty space) 109 where the interior of the through hole 104 is not filled with the conductor 105 being formed, and of an aperture portion 107 of the through hole 104 being sealed by the conductor 105 while the void 109 still exists inside the through hole 104 frequently occur (FIG. 19).

If a void 109 is generated, foreign matter such as plating solution remains inside the through hole 109 and causes a deterioration in conductivity as well as causing cracks and the like.

As a result, there is a possibility that, in no small way, such voids will have an adverse effect on the through-hole interconnections 106, on the interposer substrate 100, and on mounted electronic devices.

The present invention was conceived in view of the above-described circumstances, and it is an object thereof to provide an interposer substrate in which through-hole interconnections is formed that has no defect-generating voids in the conductor which is used to fill the interior of a through hole, and to provide a method of manufacturing an interposer substrate in which it is possible to suppress the occurrence of voids when a through hole or blind hole (non-through hole) is being filled with a conductor.

### MEANS FOR SOLVING THE PROBLEM

When the present inventors made a keen examination of the problem of the conventional manufacturing method, they discovered the following clues for solving the problem in the shape of the aperture portions 107 and 108 of the through hole 104 (see FIG. 20). Namely, the aperture portions 107 and 108 have portions 110 and 111 respectively where the cross-section has sharp points.

Here, due to the nature of plating, the plating predominantly grows on these pointed portions 110 and 111.

As a consequence, prior to the interior of the through hole 104 being filled with the conductor 105, these aperture portions 107 and 108 become blocked off which results in the void 109 being created.

Because of this, the present inventors were able to discover the following means of solution.
(1) The interposer substrate of the present invention includes a planar substrate, and through hole wiring that is formed by filling a through hole that connects together a first main surface and a second main surface of this substrate with a conductor.
   When the through hole is viewed in a vertical cross-sectional view of the substrate, the through hole has a trapezoidal shape whose side walls are formed by an inside surface of the through hole, and two side faces of the trapezoid are not parallel to each other.
   The two side faces of the trapezoid are both inclined towards the same side relative to two perpendicular lines that are perpendicular to the first main surface or the second main surface at two apex points forming a top face or a bottom face of the trapezoid.
(2) The method of manufacturing an interposer substrate is a method of manufacturing an interposer substrate that is provided with a planar substrate, and with through hole wiring that is formed by filling a through hole that connects together a first main surface and a second main surface of this substrate with a conductor.
   When the through hole is viewed in a vertical cross-sectional view of the substrate, the through hole has a trapezoidal shape whose side walls are formed by an inside surface of the through hole, and two side faces of the trapezoid are not parallel to each other.
   Moreover, the two side faces of the trapezoid are both inclined towards the same side relative to two perpendicular lines that are perpendicular to the first main surface or the second main surface at two apex points forming a top face or a bottom face of the trapezoid.
   This method of manufacturing an interposer substrate includes: modifying an area to be the through hole that connects together the first main surface and the second main surface of the substrate by irradiating the area with laser light; removing the modified region, and forming a blind hole that has a first aperture portion in the first main surface, and has an end portion to be a second aperture portion of the through hole, the end portion located inside the substrate; forming a seed layer on an inside wall of the blind hole; filling the interior of the blind hole with a conductor via the seed layer; and forming the blind hole into a through hole and forming the second aperture portion in the second main surface by grinding the second main surface.
(3) The method of manufacturing an interposer substrate is a method of manufacturing an interposer substrate that is provided with a planar substrate, and with through hole wiring that is formed by filling a through hole that connects together a first main surface and a second main surface of this substrate with a conductor.
   When the through hole is viewed in a vertical cross-sectional view of the substrate, the through hole has a trapezoidal shape whose side walls are formed by an inside surface of the through hole, and two side faces of the trapezoid are not parallel to each other.
   Moreover, the two side faces of the trapezoid are both inclined towards the same side relative to two perpendicular lines that are perpendicular to the first main surface or the second main surface at two apex points forming a top face or a bottom face of the trapezoid.
   This method of manufacturing an interposer substrate includes: modifying an area to be the through hole which connects together the first main surface and the second main surface of the substrate by irradiating the area with laser light; forming a through hole that has a first aperture portion in the first main surface, and has a second aperture portion in the second main surface by removing the modified region; attaching a conductive layer to the second main surface; and filling the interior of the through hole with a conductor via the conductive layer..
(4) The method of manufacturing an interposer substrate is a method of manufacturing an interposer substrate that is provided with a planar substrate, and with through hole wiring that is formed by filling a through hole that connects together a first main surface and a second main surface of this substrate with a conductor.
   When the through hole is viewed in a vertical cross-sectional view of the substrate, the through hole has a trapezoidal shape whose side walls are formed by an inside surface of the through hole, and two side faces of the trapezoid are not parallel to each other.

Moreover, the two side faces of the trapezoid are both inclined towards the same side relative to two perpendicular lines that are perpendicular to the first main surface or the second main surface at two apex points forming a top face or a bottom face of the trapezoid.

This method of manufacturing an interposer substrate includes: attaching a base material having a conductive layer to the second main surface of the substrate such that the conductive layer is in contact with the second main surface; modifying an area to be the through hole that connects together the first main surface and the second main surface of the substrate by irradiating the area with laser light; forming a through hole that has a first aperture portion in the first main surface, and has a second aperture portion at a boundary interface where the second main surface and the conductive layer are in mutual contact by removing the modified region; and filling the interior of the through hole with a conductor via the conductive layer..

### EFFECTS OF THE INVENTION

According to the interposer substrate described above in (1), because through-hole interconnections that has no defect-generating voids in the conductor which is used to fill the interior of a through hole is provided, the conductor does not peel away from the inside of the through hole, and neither does foreign matter that was trapped inside a void leak out.

As a result, it is possible to provide an interposer substrate that has increased reliability when devices are being mounted thereon.

According to the method of manufacturing an interposer substrate described above in (2) through (4), it is possible to suppress the occurrence of voids when a through hole or blind hole is being filled with a conductor.

As a result, it is possible to provide an interposer substrate that has increased reliability when devices are being mounted thereon.

### BRIEF DESCRIPTION OF THE DRAWINGS

FIG. 1 is a cross-sectional view showing an example of an interposer substrate according to the present invention.
FIG. 2 is a cross-sectional view showing an example of the same interposer substrate.
FIG. 3 is a perspective view showing an example of the same interposer substrate.
FIG. 4A is a plan view showing a manufacturing method for an example of the interposer substrate according to the present invention.
FIG. 4B is a cross-sectional view of FIG. 4A.
FIG. 5A is a plan view showing a first aspect of a method of manufacturing the interposer substrate according to the present invention.
FIG. 5B is a cross-sectional view of FIG. 5A.
FIG. 6A is a plan view showing the step continuing on from FIG. 5A.
FIG. 6B is a cross-sectional view of FIG. 6A.
FIG. 7A is a plan view showing the step continuing on from FIG. 6A.
FIG. 7B is a cross-sectional view of FIG. 7A.
FIG. 8A is a plan view showing the step continuing on from FIG. 7A.
FIG. 8B is a cross-sectional view of FIG. 8A.
FIG. 9A is a plan view showing a second aspect of a method of manufacturing the interposer substrate according to the present invention.
FIG. 9B is a cross-sectional view of FIG. 9A.
FIG. 10A is a plan view showing the step continuing on from FIG. 9A.
FIG. 10B is a cross-sectional view of FIG. 10A.
FIG. 11A is a plan view showing the step continuing on from FIG. 10A.
FIG. 11B is a cross-sectional view of FIG. 11A.
FIG. 12A is a plan view showing the step continuing on from FIG. 11A.
FIG. 12B is a cross-sectional view of FIG. 12A.
FIG. 13A is a plan view showing a third aspect of a method of manufacturing the interposer substrate according to the present invention.
FIG. 13B is a cross-sectional view of FIG. 13A.
FIG. 14A is a plan view showing the step continuing on from FIG. 13A.
FIG. 14B is a cross-sectional view of FIG. 14A.
FIG. 15A is a plan view showing the step continuing on from FIG. 14A.
FIG. 15B is a cross-sectional view of FIG. 15A.
FIG. 16A is a plan view showing the step continuing on from FIG. 15A.
FIG. 16B is a cross-sectional view of FIG. 16A.
FIG. 17 is a cross-sectional view showing an example of a conventional interposer substrate.
FIG. 18A is a cross-sectional view showing a conventional method of manufacturing an interposer substrate.
FIG. 18B is a cross-sectional view showing a conventional method of manufacturing an interposer substrate.
FIG. 18C is a cross-sectional view showing a conventional method of manufacturing an interposer substrate.
FIG. 18D is a cross-sectional view showing a conventional method of manufacturing an interposer substrate.
FIG. 19 is a cross-sectional view showing a state in which a void has been generated inside a through hole in the conventional method of manufacturing an interposer substrate.
FIG. 20 is a cross-sectional view showing an intermediate stage of the conventional method of manufacturing an interposer substrate.

### EMBODIMENTS FOR CARRYING OUT THE INVENTION

Hereinafter, embodiments according to the invention of the present specification will be described with reference made to the drawings.

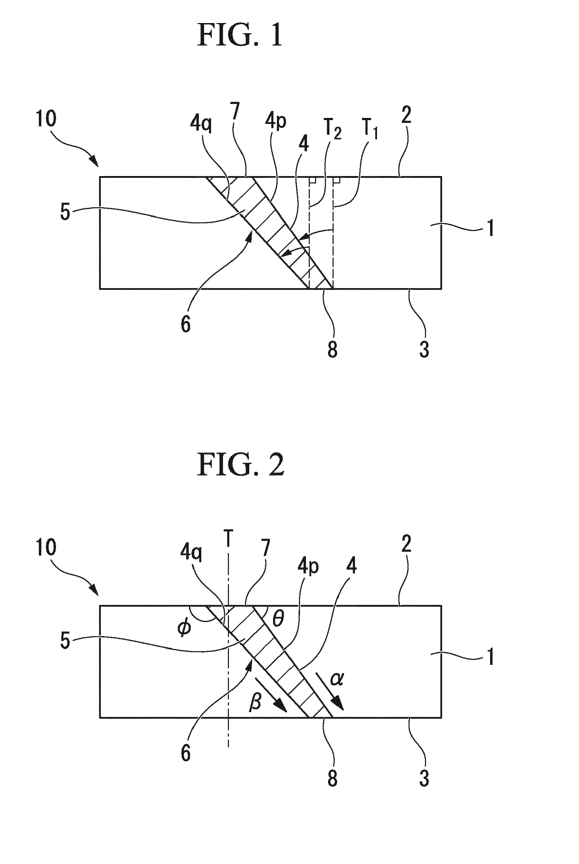

FIG. 1 is vertical cross-sectional view of an interposer substrate 10 serving as an embodiment of the present invention cut along the thickness direction thereof.

This interposer substrate 10 is provided with a planar substrate 1 and through-hole interconnections 6.

This through-hole interconnections 6 is provided with a through hole 4 that penetrates a first main surface (i.e., one main surface) 2 and a second main surface (i.e., an other main surface) 3 of the substrate 1, and with a conductor 5 that fills the interior of the through hole 4.

When the through hole is viewed in a vertical cross-sectional view of the substrate 1, the cross-sectional shape of the through hole 4 is in the form of a trapezoid whose side faces are formed by the inside surface of the through hole 4.

Two side faces 4p and 4q of this trapezoid are not parallel with each other.

Furthermore, these two side faces 4p and 4q of the trapezoid are both inclined towards the same side relative to two perpendicular lines T1 and T2 that are perpendicular to the first main surface and the second main surface at two apex points forming the top face (i.e., the first main surface) or the bottom face (i.e., the second main surface) of the trapezoid.

Note that in FIG. 1, a case in which the two perpendicular lines T1 and T2 extend from the two apex points that form the bottom face is shown, however, in the same way, when two perpendicular lines extend from the two apex points that form the top face as well, the two side faces 4p and 4q of the trapezoid are both inclined towards the same side.

In the top face of the trapezoid, a first aperture portion 7 of the through hole 4 is formed in the first main surface 2, while in the bottom face of the trapezoid, a second aperture portion 8 of the through hole 4 is formed in the second main surface 3, and the two side faces of the trapezoid form the inside surfaces (i.e., the face 4p and the face 4q) of the through hole 4.

In FIG. 1, the length of the top face is larger than the length of the bottom face (i.e., the length of the top face > the length of the bottom face).

In FIG. 1, the perpendicular lines T1 and T2 extend from the two apex points (i.e., the two ends thereof that are located on the bottom surface) that each form the bottom surface of the trapezoid to a straight line (i.e., the first main surface 2 of the substrate 1) that includes the top face which is located opposite the bottom face.

As is shown by the arrows in FIG. 1, the side face 4p of the trapezoid is inclined to the left side relative to the perpendicular line T1, and the side face 4q of the trapezoid is also inclined to the left side relative to the perpendicular line T2.

Namely, the side faces 4p and 4q are inclined to the same left side relative to the perpendicular lines T1 and T2 respectively.

FIG. 2 is a vertical cross-sectional view of the interposer substrate according to the same embodiment cut along the thickness direction thereof, and shows the same cross-section as FIG. 1.

However, in FIG. 2, the orientation (i.e., the angle) of the side faces 4p and 4q relative to a perpendicular line T that penetrates the two main surfaces of the substrate 1 is shown.

As is shown in FIG. 2, the two orientations (i.e., the orientations shown by the arrow α and the arrow β) from the first main surface 2 towards the second main surface 3 that follow the respective side faces 4p and 4q of the trapezoid travel towards the same side relative to the perpendicular line T which penetrates the two main surfaces 2 and 3 of the substrate 1.

Describing the two orientations from the first main surface 2 towards the second main surface 3 that follow the respective side faces 4p and 4q of the trapezoid as traveling towards the same side relative to the perpendicular line T in FIG. 2 refers to the fact that the directions indicated by the arrow α and the arrow β both face towards the right side of the paper relative to the perpendicular line T.

In contrast to this, if the direction indicated by the arrow α faced towards the right side of the paper relative to the perpendicular line T, while the direction indicated by the arrow β faced towards the left side of the paper relative to the perpendicular line T, then the two orientations would face towards mutually different sides relative to the perpendicular line T.

Putting the above explanation of the interposer substrate 10 in other words, the interposer substrate 10 is provided with the single substrate 1, and with the through-hole interconnections 6 that is formed by filling the interior of the through hole 4 that is formed so as to connect together the first main surface 2 and the second main surface 3 of the substrate 1 with the conductor 5.

The through hole 4 extends at an inclination relative to the first main surface 2 and the second main surface 3 of the substrate 1.

In addition, the through hole 4 narrows as it travels from the first aperture portion 7 thereof towards the second aperture portion 8 in a substantially tapered shape.

The cross-section of the interposer substrate 10 shown in FIG. 2 is a cross-section that extends from a center portion of the first aperture portion 7 to a center portion of the second aperture portion 8 of the through hole 4.

The through hole 4 extends at an inclination relative to the first main surface 2 and the second main surface 3.

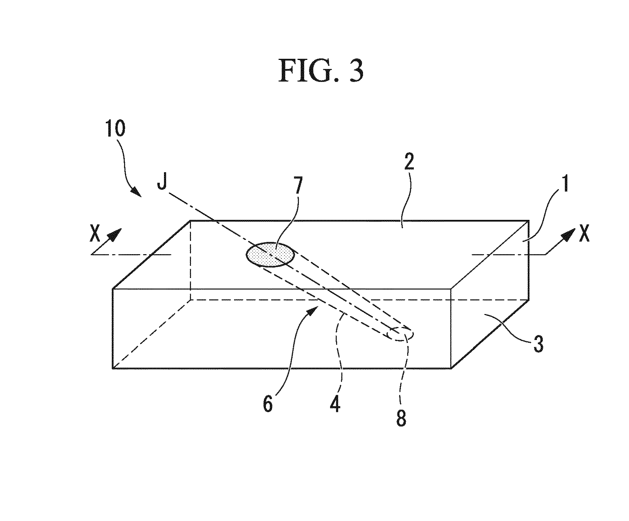

Namely, as is shown in the perspective view in FIG. 3, a central axis J of the through hole 4 extends in a different direction from the thickness direction of the substrate 1.

The central axis J passes through the center of an area of the through hole 4 that is contained within an arbitrary plane which is parallel with the first main surface 2 or the second main surface 3.

Note that FIG. 1 and FIG. 2 are cross-sectional views taken along a line X-X shown in FIG. 3.

In the cross-sectional view shown in FIG. 2, if an angle formed between the side face 4p of the through hole 4 and the first main surface 2 is expressed as θ, and an angle formed between the side face 4q and the first main surface 2 is expressed as , then the sum of the angle θ and the angle is greater than 180°.

Here, the angle θ is an acute angle, while the angle is an obtuse angle.

In this case, the side face 4p and the side face 4q extend towards the same side relative to the perpendicular line T that penetrates both main surfaces 2 and 3 of the substrate 1.

Accordingly, the shape of the through hole 4 narrows as it travels from the first aperture portion 7 towards the second aperture portion 8 in a substantially tapered shape.

The two side faces of the trapezoid are not parallel to each other, and by making them extend towards the same side relative to the perpendicular line T that penetrates both main surfaces 2 and 3 of the substrate 1, and by making the through hole 4 extend at an inclination relative to the first main surface 2 and the second main surface 3 of the substrate 1, the position of the first aperture portion 7 in the first main surface 2 and the position of the second aperture portion 8 in the second main surface 3 can be designed with a high level of design freedom.

Because of this, the through-hole interconnections 6 can be freely positioned so as to conform to the placement of the various electrode portions of the respective devices that are mounted on both surfaces of the interposer substrate 10.

In addition, by forming the through hole 4 in a substantially tapered shape that narrows as it travels from the first aperture portion 7 towards the second aperture portion 8, when the through-hole interconnections 6 is being formed during the manufacturing of the interposer substrate 10 by filling the interior of the through hole 4 with the conductor 5, it is possible to suppress the formation of voids (i.e., empty spaces).

Because of this, the interposer substrate 10 in which the through-hole interconnections 6 that has no defect-generating voids is formed has increased reliability when it is being used.

Examples of the material used for the substrate 1 of the interposer substrate 10 of the present invention include insulator such as glass (for example, silica glass), sapphire, plastic, and ceramics, and semiconductors such as silicon (Si).

Among these materials, non-conductive silica glass is preferable.

If silica glass is used as the material for the substrate, then it is not necessary to form an insulating layer on the inner wall surface of the through hole (described below), and the benefit of there being no obstructions to high-speed transmission that are caused by the presence of stray capacitance components is obtained.

The thickness (i.e., the distance from the first main surface 2 to the second main surface 3) of the substrate 1 can be appropriately set within a range of approximately 150 µm to 1 mm.

Examples of the conductor 5 that is used to fill the through hole 4 formed in the interposer substrate 10 include gold-tin (Au-Sn), copper (Cu), and the like.

The pattern of the through-hole interconnections 6 provided in the interposer substrate 10 of the present invention is not limited to the above example, and can be appropriately designed.

Next, a method of manufacturing the above-described interposer substrate 10 is described below.

The following first through third aspects illustrate the method of manufacturing the interposer substrate of the present invention.

### [First aspect of a method of manufacturing an interposer substrate]

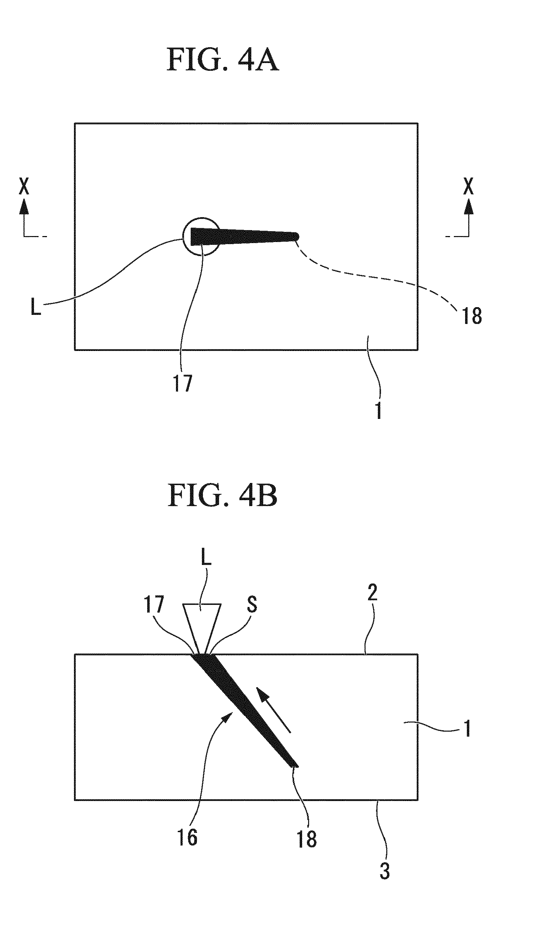

The first aspect of the method of manufacturing the interposer substrate 10 of the present invention is shown in FIG. 4A through FIG. 8B.

Here, FIG. 4A through FIG. 8B are plan views and cross-sectional views of the substrate 1 that is used to form the interposer substrate 10.

Among these, FIG. 4A, FIG. 5A, FIG. 6A, FIG. 7A, and FIG. 8A are plan views of the substrate 1.

FIG. 4B, FIG. 5B, FIG. 6B, FIG. 7B, and FIG. 8B are cross-sectional views of the substrate 1 taken along the lines X-X in the above plan views.

A first aspect of the method of manufacturing the interposer substrate 10 of the present invention may have the following five steps A to E.

### [Step A]

In step A, the area that will become the through hole 4 which will connect together the two main surfaces 2 and 3 of the substrate 1 is modified by being irradiated with laser light.

An example of this method is one in which, as is shown in FIGS. 4A and 4B, laser light L is irradiated onto the substrate 1 so as to form a modified region 16 inside the substrate 1 where the material of the substrate 1 has been modified.

The modified region 16 is provided in the area where the through-hole interconnections 6 will be formed.

The laser light L is irradiated, for example, from the first main surface 2 side of the substrate 1, and is focused on a focal point S at a desired position inside the substrate 1.

The material of the substrate 1 is modified at the position where the focal point S is focused.

Accordingly, the modified region 16 can be formed by sequentially shifting (i.e., scanning) the position of the focal point S while continually irradiating the laser light L, so that the focal point S is focused over the entire area where the through hole 4 will be formed.

An example of the light source used for the laser light L is a femtosecond laser.

A modified region 16 having a diameter ranging, for example, between several µm and several tens of µm can be obtained by this irradiation of the laser light L.

Moreover, by controlling the position where the focal point S of the laser light L is focused within the substrate 1, it is possible to form a modified region 16 having a desired shape.

The method used to irradiate this laser light L is one in which the substrate 1 is modified by, for example, irradiating the laser light L from a second end portion 18 which is located inside the substrate 1 and which will form the second aperture portion 8 of the through hole 4 towards a first end portion 17 which will form the first aperture portion 7.

At this time, the laser light L is appropriately scanned such that the diameter of the modified region 16 is formed in a shape that becomes gradually thicker as it moves from the second end portion 18 towards the first end portion 17 (namely, in a substantially tapered shape that narrows as it moves from the first end portion 17 towards the second end portion 18).

In the present embodiment, as an example, the modified region 16 is formed such that the radius of the first end portion 17 is 15 µm, the radius of the second end portion 18 is 5 µm, the angle θ is 70°, and the angle is 120°.

The arrow shown in FIG. 4B expresses the direction in which the focal point S of the laser light L is scanned.

Namely, this arrow shows that the focal point S is scanned from the second end portion 18 to the first end portion 17.

At this time, performing the scanning continuously in the direction shown by the arrow is preferable from the standpoint of manufacturing efficiency.

As is described above, when forming the modified region 16, it is possible to either irradiate the laser light L only from the first main surface 2 or second main surface 3 of the substrate 1, or to irradiate the laser light L either simultaneously or alternatingly from both of the main surfaces 2 and 3 of the substrate 1.

### [Step B]

In step B, the modified region 16 formed in step A is removed, and a blind hole 14 is created that has the first aperture portion 7 in the first main surface 2 of the substrate 1, and in which the second end portion 18 which will form the second aperture portion 8 is formed inside the substrate 1.

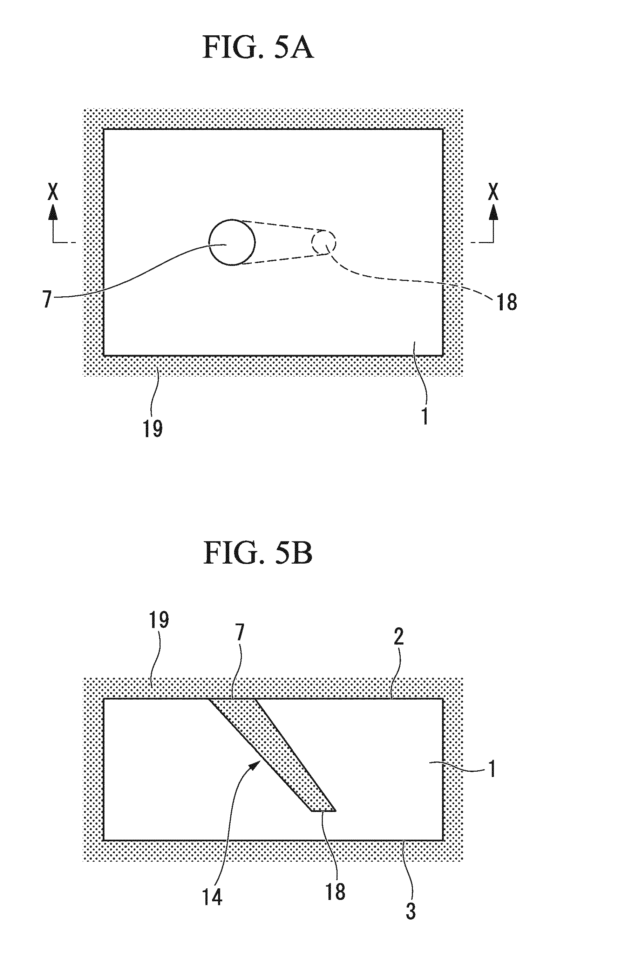

An example of the method used is a method in which, as is shown in FIGS. 5A and 5B, by immersing the substrate 1 in which the modified region 16 has been formed in an etching solution (i.e., a chemical solution) 19, the modified region 16 is etched (wet-etched) and removed from the substrate 1.

As a result, the blind hole 14 is formed in the portion where the modified region 16 was located.

In the present embodiment, a silica glass plate having a thickness of 500 µm is used as the material of the substrate 1, and a solution containing hydrofluoric acid (HF) as its primary component is used as the etching solution 19.

This etching utilizes the phenomenon that, compared with portions of the substrate 1 that were not modified, the modified region 16 is etched extremely rapidly, which results in it being possible to form the blind hole 14 in accordance with the shape of the modified region 16.

The etching solution 19 is not particularly restricted, and a solution containing hydrofluoric acid (HF) as its primary component, or a hydrofluoric-nitric acid-based mixed acid obtained by adding a suitable amount of nitric acid or the like to hydrofluoric acid can be used.

Also, other chemical solutions can be used to suit the material used for the substrate 1.

### [Step C]

In step C, a seed layer 15 is formed on the internal wall of the blind hole 14 that was formed in step B and on the first main surface 2.

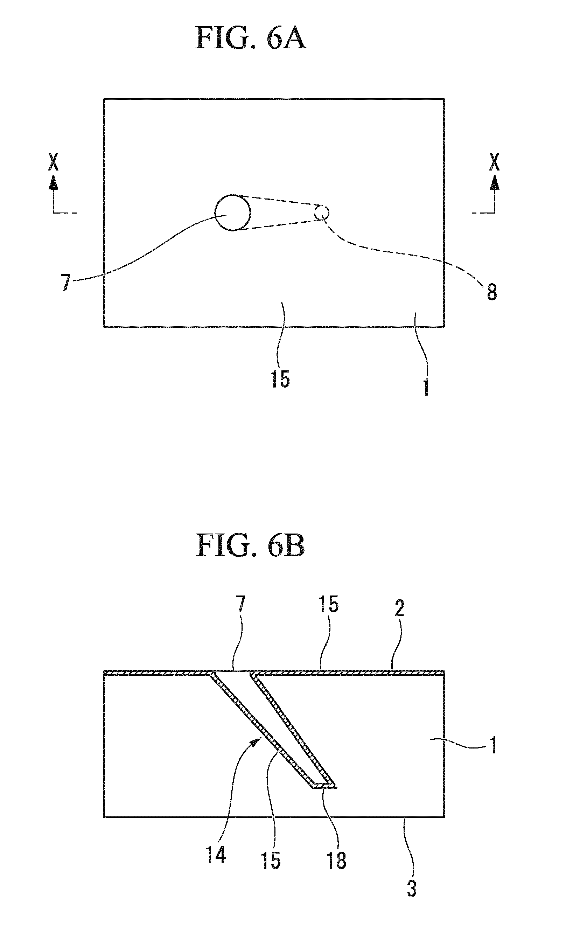

An example of the method used is one in which, as is shown in FIGS. 6A and 6B, firstly, a titanium (Ti) thin-film having a thickness of 50 nm is formed via a sputtering method on the first main surface 2 and the internal wall of the blind hole 14 of the substrate 1.

Next, a copper (Cu) thin-film having a thickness of 150 nm is formed by a sputtering method on top of the titanium thin-film.

The seed layer 15 is formed by the Cu/Ti thin-film resulting from this two-stage film formation process.

The material used for the seed layer 15 is not restricted to the aforementioned titanium and copper.

The material used for the seed layer 15 may be appropriately selected to match the material used for the conductor 5 which is employed in the subsequent filling step D.

### [Step D]

In step D, the interior of the blind hole 16 is filled with the conductor 5 via the seed layer 15 that was formed in step C.

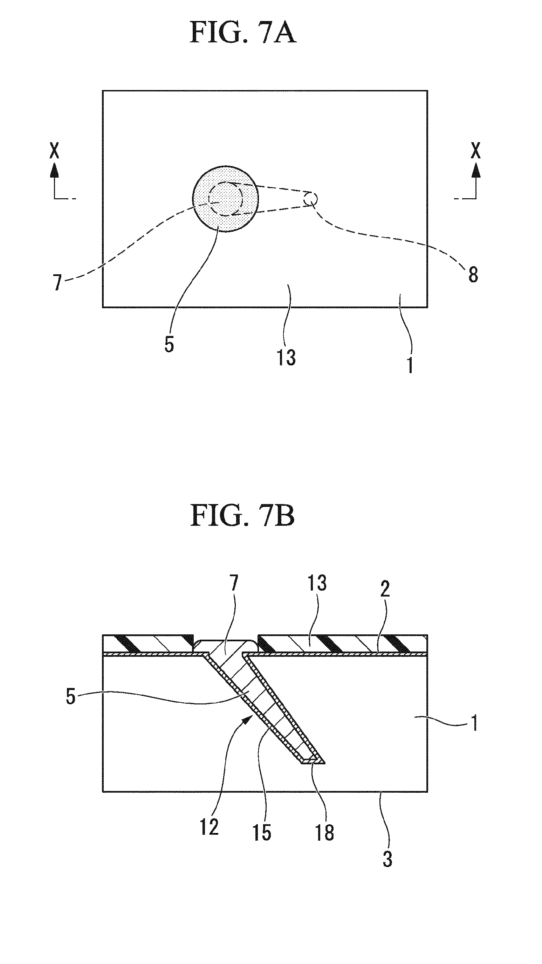

An example of the method used is one in which, as is shown in FIGS. 7A and 7B, after the surface of the seed layer 15 apart from the portions to be plated has been coated with resist 13, the substrate 1 is immersed in a plating solution (not shown).

Here, the resist 13 is patterned on areas excluding the internal wall of the blind hole 14 and the periphery of the first aperture portion 7.

A copper sulfate plating solution that is suitable for filling the blind hole 14 is ideally used as the aforementioned plating solution component.

The substrate 1 on which the resist has patterned is then immersed in the plating solution, and a suitable current is then supplied between the seed layer 15 and a separately provided anode electrode (not shown).

As a result of this, the conductor 5, namely, the plating metal is precipitated via the seed layer 15 that was not coated with the resist 13, so that the interior of the blind hole 14 is filled with the conductor 5.

The seed layer 15 and the resist layer 13 on the first main surface 2 are removed at an appropriate time after the interior of the blind hole 14 has been filled with the conductor 5.

Here, as is described above, the shape of the blind hole 14 is worked such that it becomes narrower in a substantially tapered shape as it moves from the first aperture portion 7 towards the second end portion 18 (the second aperture portion 8).

Because of this, it is possible to suppress the occurrence of areas (i.e., voids) where the conductor 5 has blocked off the first aperture portion 7 but has not actually filled the interior of the blind hole 14.

Namely, because the blind hole 14 in which the seed layer 15 is formed has a shape that becomes gradually wider as it moves from the second end portion 18 towards the first aperture portion 7, when the conductor 5 is precipitated by the plating via the seed layer 15, the second end portion 18, which is located on the narrow side, is filled with the conductor 5 before the first aperture portion, which is located on the wide side.

Consequently, it is possible to suppress the occurrence of defect-generating voids inside the conductor 5 after this has been used to fill the blind hole 14, and it is possible to obtain the blind hole 12 which has been tightly filled with the conductor 5.

### [Step E]

In step E, the second main surface 3 of the substrate 1 having the blind-hole 12 with the conductor which was formed in step D is ground (i.e., polished) such that the blind hole 14 and the blind hole interconnections 12 are formed respectively into the through hole 4 and the through-hole interconnections 6, and the second aperture portion 8 is formed in the second main surface 3.

More specifically, the second main surface 3 is ground off until the substrate 1 is thinned down to a desired thickness that allows the second end portion 18 which is located inside the substrate 1 to be exposed at the second main surface 3.

It is also possible for the first main surface 2 to be ground off.

By grinding off the first main surface 2, the surface of the conductor 5 in the first aperture portion 7 can be made smooth.

A physical - chemical method such as mechanical chemical polishing (MCP) or the like may be used as this grinding method.

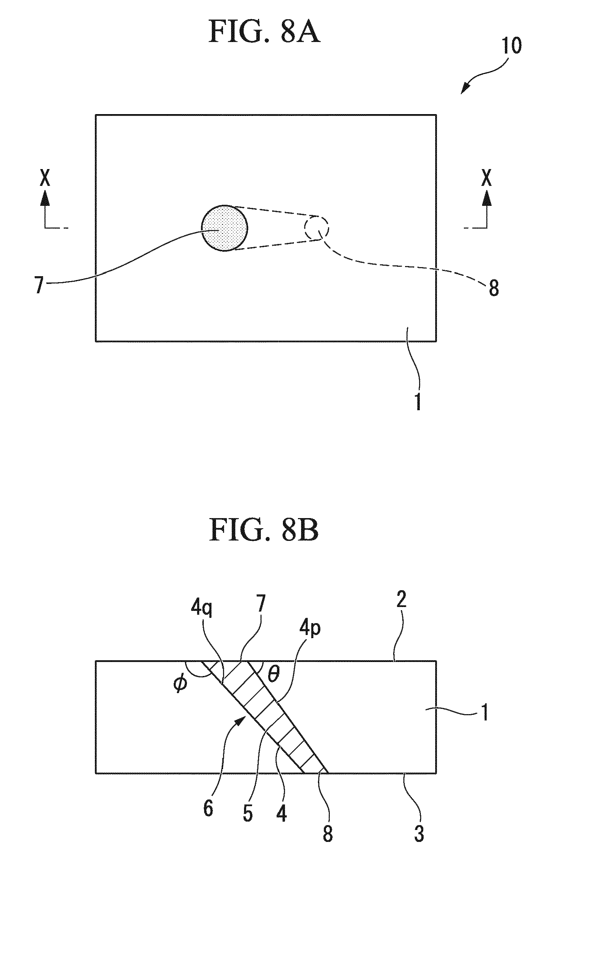

By performing the above-described steps A through E, the interposer substrate 10 shown in FIGS. 8A and 8B is obtained.

### [Second aspect of the method of manufacturing an interposer substrate]

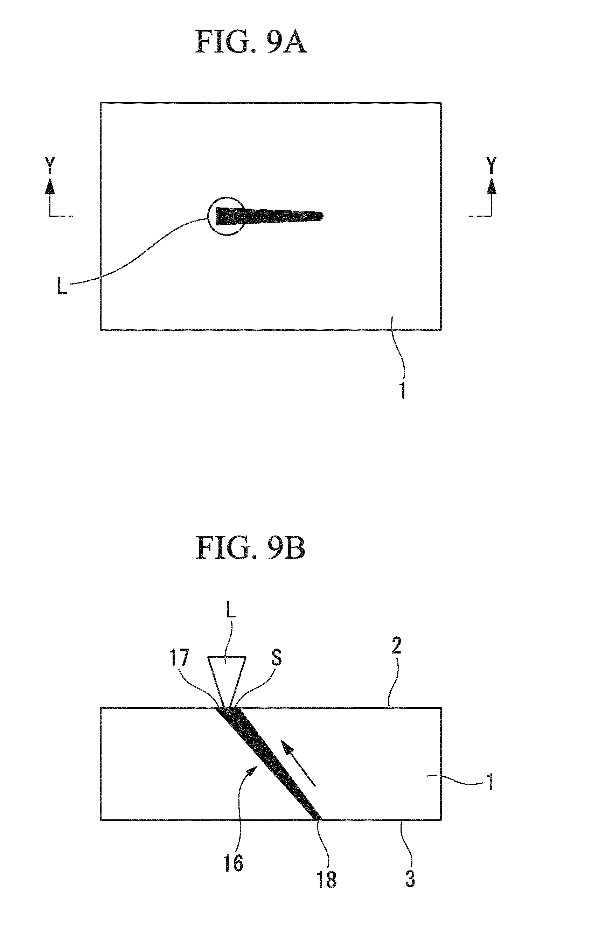

Next, a second aspect of the method of manufacturing the interposer substrate 10 of the present invention is shown in FIG. 9A through FIG. 12B.

Here, FIG. 9A through FIG. 12B are plan views and cross-sectional views of the substrate 1 that is used to manufacture the interposer substrate 10.

Among these, FIG. 9A, FIG. 10A, FIG. 11A, and FIG. 12A are plan views of the substrate 1.

FIG. 9B, FIG. 10B, FIG. 11B, and FIG. 12B are cross-sectional views of the substrate 1 taken along the lines Y-Y in the above plan views.

The second aspect of the method of manufacturing the interposer substrate 10 of the present invention may have the following four steps G to J.

### [Step G]

In step G, the substrate 1 is modified by irradiating the area that will become the through hole 4 which will connect together the two main surfaces 2 and 3 of the substrate 1 with laser light.

An example of this method is one in which, as is shown in FIGS. 9A and 9B, laser light L is irradiated onto the substrate 1 so as to form a modified region 16 inside the substrate 1 where the material of the substrate 1 has been modified.

The modified region 16 is provided in the area where the through-hole interconnections 6 will be formed.

The description of the material used to form the substrate 1, the modification of the substrate 1 at the focal point S of the laser light L, and the description of the light source of the laser light L are the same as in the foregoing description of the first aspect of the method of manufacturing an interposer substrate.

The method used to irradiate the laser light L is one in which the substrate 1 is modified by, for example, irradiating the laser light L from the second end portion 18 which will form the second aperture portion 8 of the through hole 4 towards the first end portion 17 which will form the first aperture portion 7.

At this time, the laser light L is appropriately scanned such that the diameter of the modified region 16 is formed in a shape that becomes gradually thicker as it moves from the second end portion 18 towards the first end portion 17 (namely, in a substantially tapered shape that narrows as it moves from the first end portion 17 towards the second end portion 18).

In the present embodiment, the modified region 16 is formed such that the radius of the first end portion 17 is 15 µm, the radius of the second end portion 18 is 5 µm, the angle θ is 70°, and the angle is 120°.

The arrow shown in FIG. 9B expresses the direction in which the focal point S of the laser light L is scanned.

Namely, this arrow shows that the focal point S is scanned from the second end portion 18 to the first end portion 17.

At this time, performing the scanning continuously in the direction shown by the arrow is preferable from the standpoint of manufacturing efficiency.

As is described above, when forming the modified region 16, it is possible to either irradiate the laser light L only from the first main surface 2 or second main surface 3 of the substrate 1, or to irradiate the laser light L either simultaneously or alternatingly from both of the main surfaces 2 and 3 of the substrate 1.

### [Step H]

In step H, the modified region 16 formed in step G is removed, and a through hole 4 is created that has the first aperture portion 7 in the first main surface 2 of the substrate 1, and has the second aperture portion 8 in the second main surface 3 of the substrate 1.

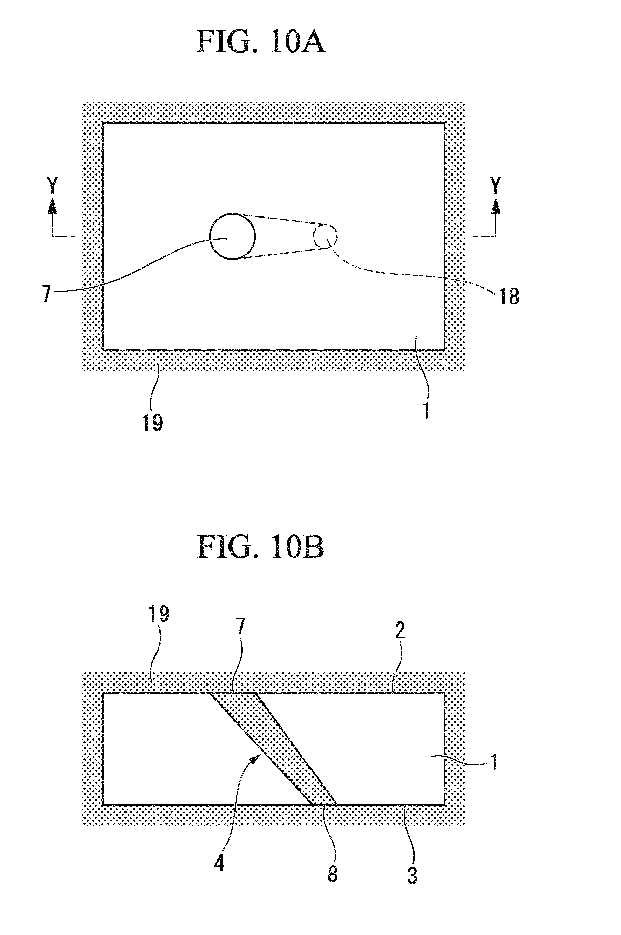

An example of the method used is a method in which, as is shown in FIGS. 10A and 10B, by immersing the substrate 1 in which the modified region 16 has been formed in an etching solution (i.e., a chemical solution) 19, the modified region 16 is etched (wet-etched) and removed from the substrate 1.

As a result, the through hole 4 (i.e., a via) is formed in the portion where the modified region 16 was located.

In the present embodiment, a silica glass plate having a thickness of 500 µm is used as the material of the substrate 1, and a solution containing hydrofluoric acid (HF) as its primary component is used as the etching solution 19.

This etching utilizes the phenomenon that, compared with portions of the substrate 1 that were not modified, the modified region 16 is etched extremely rapidly, which results in it being possible to form the through hole 4 in accordance with the shape of the modified region 16.

In addition to this, after a modified region has been formed in a rectilinear shape, it is also possible to form a tapered hole by appropriately selecting a solution having a low selection ratio (i.e., a ratio between the etching rates of the modified layer and the non-modified layer) for the etching solution, and causing the etching to progress continually from only one surface (for example, the first main surface 2 side) of the substrate 1.

The etching solution 19 is not particularly restricted, and a solution containing hydrofluoric acid (HF) as its primary component, or a hydrofluoric-nitric acid-based mixed acid obtained by adding a suitable amount of nitric acid or the like to hydrofluoric acid can be used.

Also, other chemical solutions can be used to suit the material used for the substrate 1.

### [Step I]

In step I, a conductive layer 21 is attached to the second main surface 3.

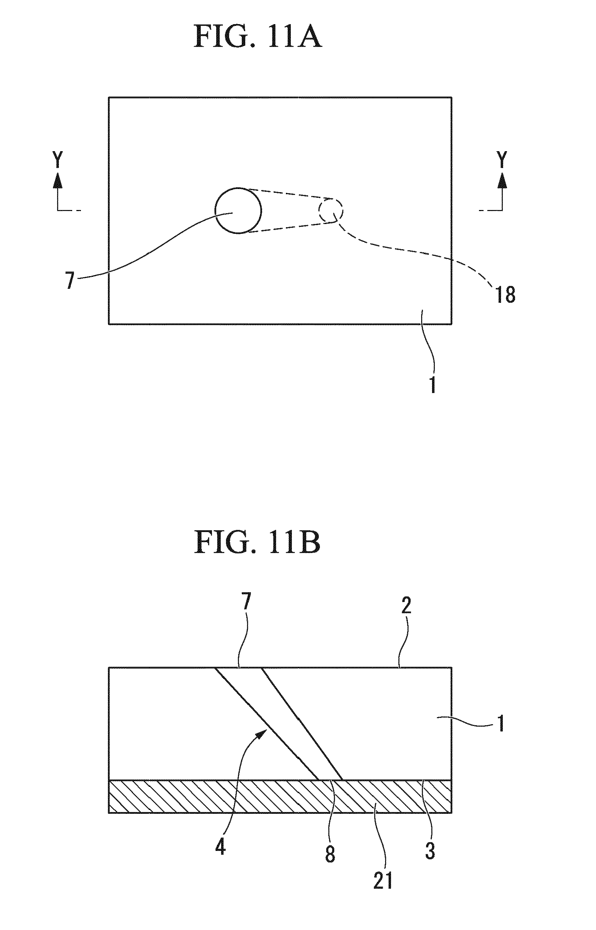

An example of the method used for this is one in which, as is shown in FIG. 11B, a conductive layer 21 that is formed from a copper plate having a thickness of 1 mm is firmly fixed to the second main surface 3 using a jig (not shown).

The material used to form the conductive layer 21 is not restricted to copper, and it is also possible to use a conductive substance such as titanium, gold, or gold-tin or the like whose thickness has been appropriately set.

### [Step J]

In step J, the interior of the through hole 4 is filled with the conductor 5 via the conductive layer 21 that was fixed in step I.

An example of the method used for this is one in which the substrate 1 on whose second main surface 3 the conductive layer 21 has been attached is immersed in a plating solution (not shown).

A copper sulfate plating solution that is suitable for filling the through hole 4 is ideally used as the aforementioned plating solution component.

The substrate 1 is then immersed in the plating solution, and a suitable current is then supplied between the conductive layer 21 and a separately provided anode electrode (not shown).

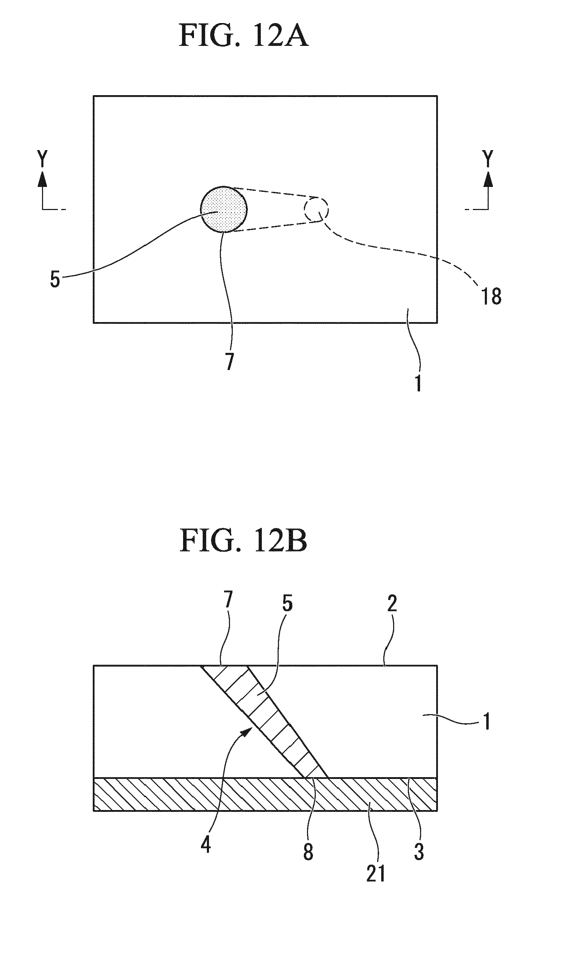

As a result of this, the conductor 5, namely, the plating metal is precipitated via the portions where the conductive layer 21 is in contact with the second aperture portion 8 of the through hole 4, so that the interior of the through hole 4 is filled with the conductor 5 (see FIGS. 12A and 12B).

Here, as is described above, the shape of the through hole 4 is worked such that it becomes narrower in a substantially tapered shape as it moves from the first aperture portion 7 towards the second aperture portion 8.

Because of this, it is possible to suppress the occurrence of areas (i.e., voids) where the conductor 5 has blocked off the first aperture portion 7 but has not actually filled the interior of the through hole 4.

Namely, because the through hole 4 has a shape that becomes gradually wider as it moves from the second aperture portion 8 towards the first aperture portion 7, then because the conductor 5 is precipitated by the plating via the conductive layer 21 such that the through hole 4 is filled with the conductor 5 starting from the second aperture portion 8, which is located on the narrow side, and then proceeding towards the first aperture portion 7, which is located on the wide side, the plating solution inside the through hole 4 is replaced with a smoothly precipitated conductor.

Consequently, because a state is obtained in which the interior of the through hole 4 is uniformly filled with fresh plating solution, stable plating growth with no precipitation abnormalities is achieved.

As a result, it is possible to suppress the occurrence of defect-generating voids inside the conductor 5 after this has been used to fill the through hole 4, and it is possible to obtain through-hole interconnections 6 in which the interior of the through hole 4 has been tightly filled with the conductor 5.

The conductive layer 21 is then removed by means of an appropriate method from the second main surface 3 of the interposer substrate 10 in which the through-hole interconnections 6 has been formed.

It is also possible, by polishing the two main surfaces of the interposer substrate 10, to smoothen the surfaces of the conductor 5 that are exposed at the first aperture portion 7 and the second aperture portion 8.

By performing the above-described steps G through J, the interposer substrate 10 shown in FIGS. 8A and 8B is obtained.

In the manufacturing method of the second aspect that is described here, because it is not essential for steps such as the patterning resist and the grinding of the second main surface 3 and the like to be performed, the number of steps can be decreased compared to the above-described manufacturing method of the first aspect.

Consequently, the manufacturing efficiency is excellent.

Additionally, because the conductor 5 is precipitated via the conductive layer 21 which is in contact with the second aperture portion 8, there is a tendency for the through hole 4 to be filled with the conductor 5 from the second aperture portion 8 towards the first aperture portion 7.

As a result, it is possible to suppress the formation of voids in the through-hole interconnections 6 even more completely.

### [Third aspect of the method of manufacturing an interposer substrate]

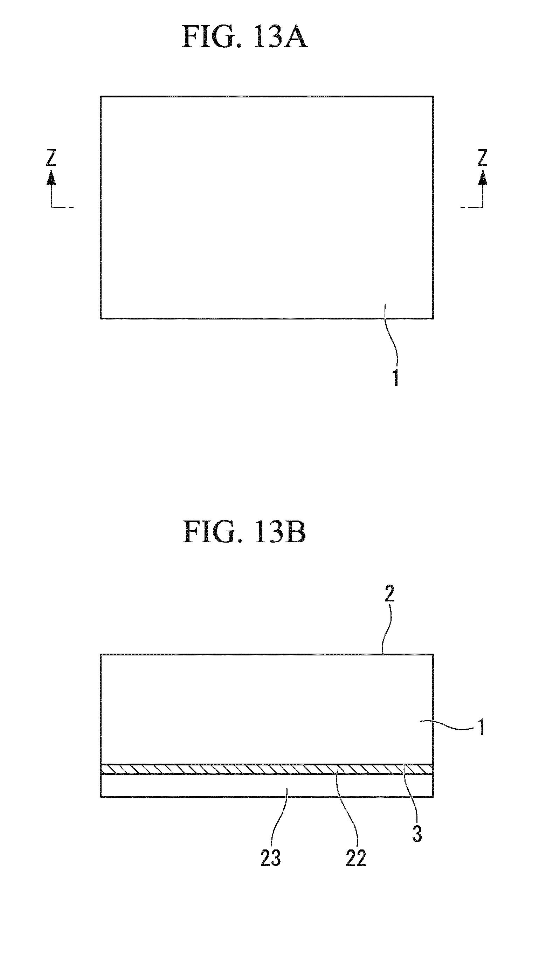

Next, a third aspect of the method of manufacturing the interposer substrate 10 of the present invention is shown in FIG. 13A through FIG. 16B.

Here, FIG. 13A through FIG. 16B are plan views and cross-sectional views of the substrate 1 that is used to manufacture the interposer substrate 10.

Among these, FIG. 13A, FIG. 14A, FIG. 15A, and FIG. 16A are plan views of the substrate 1.

FIG. 13B, FIG. 14B, FIG. 15B, and FIG. 16B are cross-sectional views of the substrate 1 taken along the lines Z-Z in the above plan views.

The third aspect of the method of manufacturing the interposer substrate 10 of the present invention may have the following four steps M to P.

### [Step M]

In step M, a base material 23 having a conductive layer 22 is attached to the second main surface 3 of the substrate 1 such that the conductive layer 22 is in contact with the second main surface 3.

An example of the method used for this is one in which, as is shown in FIG. 13B, a base material 23 that is made from resin and that has a conductive layer 22 that is formed from a copper thin-film having a thickness of 50 µm provided on one surface thereof is firmly attached to the second main surface 3 of the substrate 1 using a jig (not shown) such that the conductive layer 22 is in contact with the second main surface 3.

One example of the method used to form the copper thin-film on one surface of the base material 23 is a sputtering method.

The material used to form the conductive layer 22 is not restricted to copper, and it is also possible to use a conductive substance such as titanium, gold, gold-tin and the like whose thickness has been appropriately set.

The material used to form the base material 23 is not limited to resin, and may also be a semiconductor substrate formed from Si or the like, or may be a metal plate.

The thickness thereof may also be appropriately set.

### [Step N]

In step N, the substrate 1 is modified by irradiating the area that will become the through hole 4 which will connect together the two main surfaces 2 and 3 of the substrate 1 with laser light L.

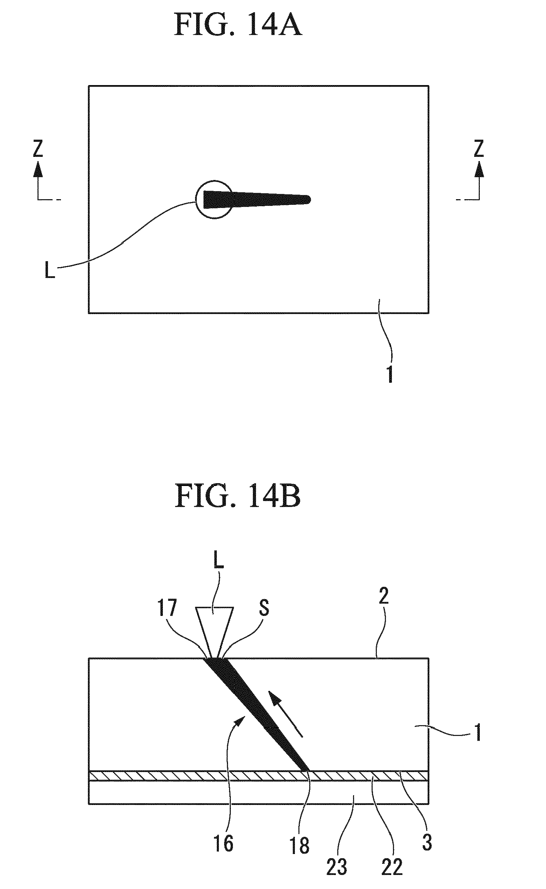

An example of this method is one in which, as is shown in FIGS. 14A and 14B, the laser light L is irradiated onto the substrate 1 so as to form a modified region 16 inside the substrate 1 where the material of the substrate 1 has been modified.

The modified region 16 is provided in the area where the through-hole interconnections 6 will be formed.

The description of the material used to form the substrate 1, the modification of the substrate 1 at the focal point S of the laser light L, and the description of the light source of the laser light L are the same as in the foregoing description of the first aspect of the method of manufacturing an interposer substrate.

The method used to irradiate the laser light L is one in which the substrate 1 is modified by, for example, irradiating the laser light L starting from the second end portion 18 which will form the second aperture portion 8 of the through hole 4 towards the first end portion 17 which will form the first aperture portion 7.

At this time, the laser light L is appropriately scanned such that the diameter of the modified region 16 is formed in a shape that becomes gradually thicker as it moves from the second end portion 18 towards the first end portion 17 (namely, in a substantially tapered shape that narrows as it moves from the first end portion 17 towards the second end portion 18).

In the present embodiment, the modified region 16 is formed such that the radius of the first end portion 17 is 15 µm, the radius of the second end portion 18 is 5 µm, the angle θ is 70°, and the angle is 120°.

The arrow shown in FIG. 14B expresses the direction in which the focal point S of the laser light L is scanned.

Namely, this arrow shows that the focal point S is scanned from the second end portion 18 to the first end portion 17.

At this time, performing the scanning continuously in the direction shown by the arrow is preferable from the standpoint of manufacturing efficiency.

As is described above, when forming the modified region 16, it is possible to either irradiate the laser light L only from the first main surface 2 or second main surface 3 of the substrate 1, or to irradiate the laser light L either simultaneously or alternatingly from both of the main surfaces 2 and 3 of the substrate 1.

### [Step O]

In step O, the modified region 16 formed in step N is removed, and a through hole 4 is created that has the first aperture portion 7 in the first main surface 2 of the substrate 1, and has the second aperture portion 8 at a boundary interface where the second main surface 3 and the conductive layer 22 are in mutual contact.

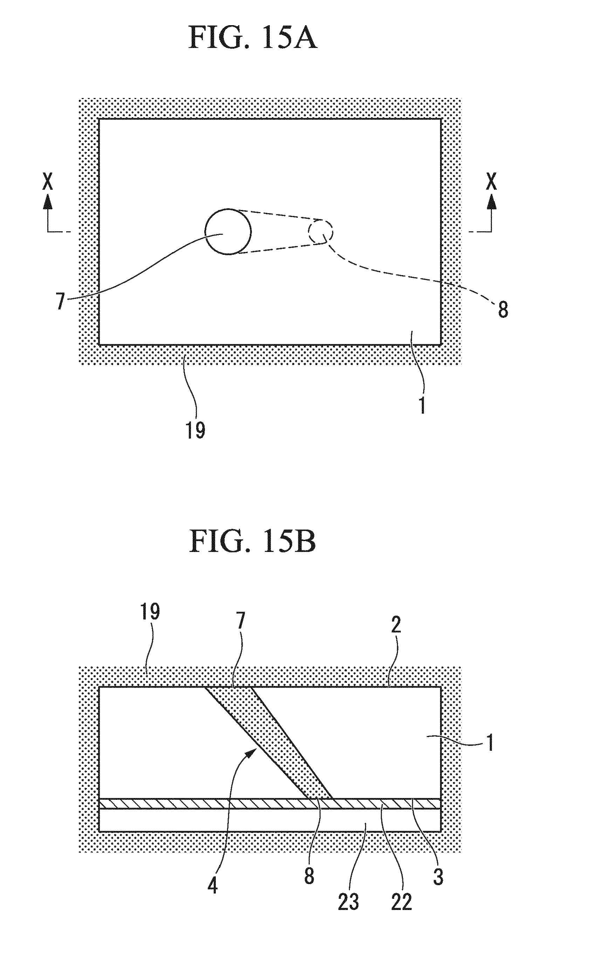

An example of the method used is a method in which, as is shown in FIGS. 15A and 15B, by immersing the substrate 1 in which the modified region 16 has been formed in an etching solution (i.e., a chemical solution) 19, the modified region 16 is etched (wet-etched) and removed from the substrate 1.

As a result, the through hole 4 (i.e., a via) is formed in the portion where the modified region 16 was located.

In the present embodiment, a silica glass plate having a thickness of 500 µm is used as the material of the substrate 1, and a solution containing hydrofluoric acid (HF) as its primary component is used as the etching solution 19.

This etching utilizes the phenomenon that, compared with portions of the substrate 1 that were not modified, the modified region 16 is etched extremely rapidly, which results in it being possible to form the through hole 4 in accordance with the shape of the modified region 16.

In addition to this, after a modified region has been formed in a rectilinear shape, it is also possible to form a tapered hole by appropriately selecting a solution having a low selection ratio (i.e., a ratio between the etching rates of the modified layer and the non-modified layer) for the etching solution, and causing the etching to progress continually from only one surface (for example, the first main surface 2 side) of the substrate 1.

The etching solution 19 is not particularly restricted, and a solution containing hydrofluoric acid (HF) as its primary component, or a hydrofluoric-nitric acid-based mixed acid obtained by adding a suitable amount of nitric acid or the like to hydrofluoric acid can be used.

Also, other chemical solutions can be used to suit the material used for the substrate 1.

### [Step P]

In step P, the interior of the through hole 4 is filled with the conductor 5 via the conductive layer 22 that was provided on one surface of the base material 23 which was firmly fixed to the second main surface 3 of the substrate 1 in step M.

An example of the method used for this is one in which the substrate 1 on whose second main surface 3 the conductive layer 22 has been attached is immersed in a plating solution (not shown).

A copper sulfate plating solution that is suitable for filling the through hole 4 is ideally used as the aforementioned plating solution component.

The substrate 1 is then immersed in the plating solution, and a suitable current is then supplied between the conductive layer 22 and a separately provided anode electrode (not shown).

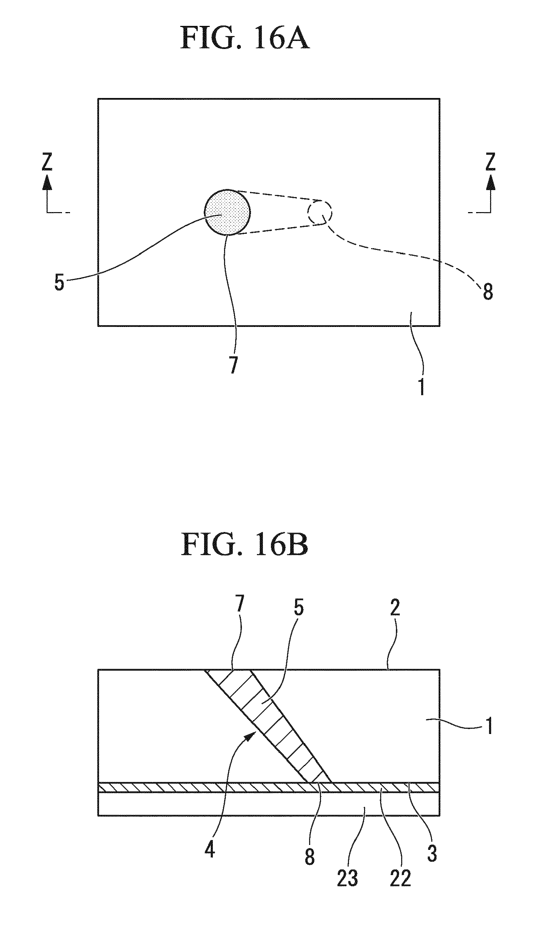

As a result of this, the conductor 5, namely, the plating metal is precipitated via the portions where the conductive layer 22 is in contact with the second aperture portion 8 of the through hole 4, so that the interior of the through hole 4 is filled with the conductor 5 (see FIGS. 16A and 16B).

Here, as is described above, the shape of the through hole 4 is worked such that it becomes narrower in a substantially tapered shape as it moves from the first aperture portion 7 towards the second aperture portion 8.

Because of this, it is possible to suppress the occurrence of areas (i.e., voids) where the conductor 5 has blocked off the first aperture portion 7 but has not actually filled the interior of the through hole 4.

Namely, because the through hole 4 has a shape that becomes gradually wider as it moves from the second aperture portion 8 towards the first aperture portion 7, then because the conductor 5 is precipitated by the plating via the conductive layer 22 such that the through hole 4 is filled with the conductor 5 starting from the second aperture portion 8, which is located on the narrow side, and then proceeding towards the first aperture portion 7, which is located on the wide side, the plating solution inside the through hole 4 is replaced with a smoothly precipitated conductor.

Consequently, because a state is obtained in which the interior of the through hole 4 is uniformly filled with fresh plating solution, stable plating growth with no precipitation abnormalities is achieved.

As a result, it is possible to suppress the occurrence of defect-generating voids inside the conductor 5 after this has been used to fill the through hole 4, and it is possible to obtain through-hole interconnections 6 in which the interior of the through hole 4 has been tightly filled with the conductor 5.

The conductive layer 22 and the base material 23 are then removed by means of an appropriate method from the second main surface 3 of the interposer substrate 10 in which the through-hole interconnections 6 has been formed.

It is also possible, by polishing the two main surfaces of the interposer substrate 10, to smoothen the surfaces of the conductor 5 that are exposed at the first aperture portion 7 and the second aperture portion 8.

By performing the above-described steps M through P, the interposer substrate 10 shown in FIGS. 8A and 8B is obtained.

In the manufacturing method of the third aspect that is described here, because it is not essential for steps such as patterning the resist and the grinding of the second main surface 3 and the like to be performed, the number of steps can be decreased compared to the above-described manufacturing method of the first aspect.

Consequently, the manufacturing efficiency is excellent.

In addition, because the conductor 5 is precipitated via the conductive layer 22 which is in contact with the second aperture portion 8, there is a tendency for the through hole 4 to be filled with the conductor 5 from the second aperture portion 8 towards the first aperture portion 7.

As a result, it is possible to suppress the formation of voids in the through-hole interconnections 6 even more completely.

### INDUSTRIAL APPLICABILITY

By employing the interposer substrate of the present invention, the interconnect through hole substrate can be favorably used in the high-density packaging of various types of devices such as three-dimensional packaging in which devices are mounted on both main surfaces thereof, or in system-in-packaging (SiP) in which a plurality of devices are systematized within a single package.

### DESCRIPTION OF THE REFERENCE SYMBOLS

- 1: Substrate
- 2: First main surface
- 3: Second main surface
- 4: Through hole
- 5: Conductor
- 6: Through-hole interconnections
- 7: First aperture portion
- 8: Second aperture portion
- 10: Interposer substrate
- 13: Resist
- 14: Blind hole
- 15: Seed layer
- 16: Modified region
- 17: First (one) end portion
- 18: Second (other) end portion
- 19: Etching solution
- 21: Conductive layer
- 22: Conductive layer
- 23: Base material
- L: Laser light
- T, T1, T2: Perpendicular line

## Claims

1. A method of manufacturing an interposer substrate that is provided with a planar substrate, and with a through hole interconnection that is formed by filling a through hole that connects together a first main surface and a second main surface of this substrate with a conductor, comprising:
modifying an area to be the through hole which connects together the first main surface and the second main surface of the substrate by irradiating the area with laser light, so that when the through hole is viewed in a vertical cross-sectional view of the substrate, the through hole has a trapezoidal shape, wherein the side walls are formed by an inside surface of the through hole, and two side faces of the trapezoid are not parallel to each other, and the two side faces of the trapezoid are both inclined towards the same side relative to two perpendicular lines that are perpendicular to the first main surface or the second main surface at two apex points forming a top face or a bottom face of the trapezoid,
forming a through hole that has a first aperture portion in the first main surface, and has a second aperture portion in the second main surface by removing the modified region;
attaching a conductive layer to the second main surface; and
filling the interior of the through hole with a conductor via the conductive layer.

2. A method of manufacturing an interposer substrate that is provided with a planar substrate, and with through hole wiring that is formed by filling a through hole that connects together a first main surface and a second main surface of this substrate with a conductor, comprising:
attaching a base material having a conductive layer to the second main surface of the substrate such that the conductive layer is in contact with the second main surface;
modifying an area to be the through hole that connects together the first main surface and the second main surface of the substrate by irradiating the area with laser light so that when the through hole is viewed in a vertical cross-sectional view of the substrate the through hole has a trapezoidal shape wherein the side walls are formed by an inside surface of the through hole, and two side faces of the trapezoid are not parallel to each other, and the two side faces of the trapezoid are both inclined towards the same side relative to two perpendicular lines that are perpendicular to the first main surface or the second main surface at two apex points forming a top face or a bottom face of the trapezoid,
forming a through hole that has a first aperture portion in the first main surface, and has a second aperture portion at a boundary interface where the second main surface and the conductive layer are in mutual contact by removing the modified region; and
filling the interior of the through hole with a conductor via the conductive layer.
